Europäisches Patentamt

European Patent Office

Office européen des brevets

(19)

(11) Veröffentlichungsnummer: **0 194 487**
**B1**

(12) **EUROPÄISCHE PATENTSCHRIFT**

(45) Veröffentlichungstag der Patentschrift: **18.07.90**

(21) Anmeldenummer: **86102263.0**

(22) Anmeldetag: **21.02.86**

(51) Int. Cl.⁵: **G 03 B 41/00,** G 01 B 11/16,
H 01 L 21/68

(54) **Verfahren zur Lagebestimmung eines Objekts in einem automatisierten Fertigungsverfahren und Vorrichtung zur Durchführung des Verfahrens.**

(30) Priorität: **28.02.85 DE 3507116**

(43) Veröffentlichungstag der Anmeldung:
**17.09.86 Patentblatt 86/38**

(45) Bekanntmachung des Hinweises auf die
Patenterteilung:
**18.07.90 Patentblatt 90/29**

(84) Benannte Vertragsstaaten:
**CH DE FR GB IT LI NL**

(56) Entgegenhaltungen:
**EP-A-0 077 878**
**FR-A-2 295 569**
**FR-A-2 311 403**
**US-A-4 322 162**

**PATENTS ABSTRACTS OF JAPAN, Band 8, Nr.
63 (E-233) 1500r, 24. März 1984 & JP-A-58-213
437**

(73) Patentinhaber: **Siemens Aktiengesellschaft
Wittelsbacherplatz 2
D-8000 München 2 (DE)**

(72) Erfinder: **Häfele, Eberhard, Dipl.-Ing.
Anton-Bruckner-Strasse 24
D-8200 Rosenheim (DE)**
Erfinder: **Wilde, Rüdiger
Züricher Strasse 186
D-8000 München 71 (DE)**

Courier Press, Leamington Spa, England.

EP 0 194 487 B1

**Beschreibung**

Die Erfindung betrifft ein Verfahren zur Lagebestimmung eines Objekts relativ zu einer Normalposition in einem automatisierten Fertigungsverfahren, beispielsweise eines Halbleiterchips in einer sogenannten Bond-Vorrichtung, sowie eine Vorrichtung zur Durchführung des Verfahrens, wie sie in den Oberbegriffen der unabhängigen Ansprüche beschrieben sind.

Ein bei der Massenfertigung von Halbleiterbauelementen notwendiger Fertigungsschritt besteht darin, die aus einer Scheibe (Wafer) ausgesägten und auf einer elastischen Haftfolie angeordneten einzelnen Chips abzunehmen und der Weiterverarbeitung zuzuführen. Dazu muß die Lage des betreffenden Chips festgestellt und relativ zu einer Abnahmevorrichtung, die beispielsweise aus einem Saugkopf besteht, ausgerichtet werden.

Die dabei benutzten Erkennungssysteme machen sich den Helligkeitskontrast von Sägespur und Chipoberfläche zunutze. Um ein sicheres Unterscheiden zu gewährleisten, muß der Dunkelanteil in einem bestimmten Verhältnis zum Hellanteil stehen, d.h., Sägespur und Chipgröße müssen in einem Mindestverhältnis stehen. Dies ist bisher nur dadurch möglich, daß die Trägerfolie abhängig von der Chipgröße gespreizt wird.

Bei diesem Vorgang wird die Folie konzentrisch auseinandergezogen, so daß der Abstand von benachbarten Chips entsprechend vergrößert wird. Da in der Praxis jedoch keine gleichmäßige Spreizung der Folie möglich ist, können sich Lageungenauigkeiten in der x- und y-Richtung der Folienebene ebenso wie Winkelveränderungen ergeben. Ferner kann der Scheibendurchmesser einer undefinierten Änderung ausgesetzt sein. Das hat neben langen Justierzeiten zur Folge, daß aufgrund der teilweise nicht korrigierbaren Abweichungen technische Probleme bei der Weiterverarbeitung und Qualitätsminderungen auftreten können.

Ein Beispiel für eine nach diesem Verfahren arbeitende Bond-Vorrichtung ist in der DE—OS 26 20 599 beschrieben. Eine weitere derartige Vorrichtung ist aus der EP—B1—40 580 bekannt.

Der Erfindung lag die Aufgabe zugrunde, ein Verfahren der obengenannten Art und eine Vorrichtung zur Durchführung des Verfahrens mit einem verbesserten Hell-Dunkel-Kontrast anzugeben.

Diese Aufgabe wird gemäß den kennzeichnenden Teilen der unabhängigen Ansprüche gelöst.

Die Erfindung beruht darauf, daß gebündeltes Licht, das auf das Objekt und seine Umgebung gerichtet ist, unterschiedlich abgelenkt wird, wenn das Objekt und seine Umgebung unterschiedlich ausgelenkt werden. Der auswertenden Optik wird lediglich einer der Teilstrahlen zugeführt, so daß ein starker Helligkeitskontrast wahrnehmbar ist.

Auf dem speziellen Anwendungsgebiet des Chip-Bondens hat die Erfindung den Vorteil, daß die ursprüngliche Lage des Chips auf der Folie beibehalten wird, d.h. die x-, y- und φ-Parameter bleiben erhalten. Dadurch ergeben sich qualitative Verbesserungen durch erhöhte Lagegenauigkeit des abgehobenen Chips, Verkürzung der Justierzeiten sowie Einsparung von Ausrüstung und Arbeitszeit für das Spreizen der Folie. Die Beanspruchung des Folienträgers aufgrund der erfindungsgemäßen Auslenkung liegt im zulässigen elastischen Bereich.

Weiterbildungen der Erfindung ergeben sich aus den Unteransprüchen.

Im folgenden wird die Erfindung anhand eines Ausführungsbeispieles weiter beschrieben.

Die Figuren 1, 3 und 5 zeigen schematisch jeweils einen Verfahrensschritt und die erforderliche Vorrichtung.

Die Figuren 2 und 4 zeigen schematisch eine zur Figur 1 bzw. 3 gehörige Wiedergabe des Helligkeitskontrastes.

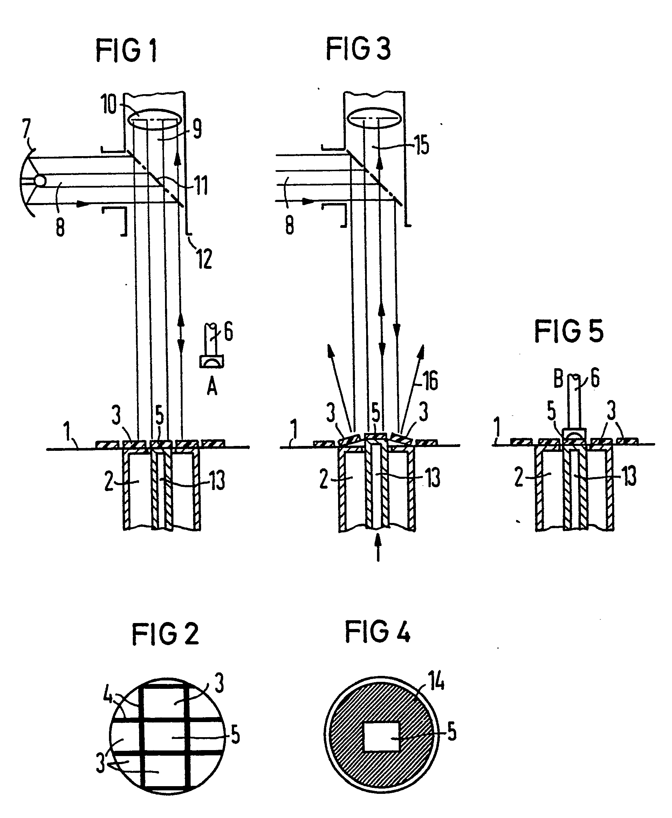

Wie Fig. 1 in einer Bereitstellungsphase zeigt, ist ein elastischer Träger 1 mit darauf befindlichen Objekten, im Beispiel Halbleiterchips 3, 5, über einem Halterungsbett 2 angeordnet. Der Träger 1 besteht aus einer mit Klebstoff beschichteten Folie, auf der ein in die einzelnen Chips 3, 5 zersägter Wafer haftet. Die Abstände zwischen den Chips 3, 5 entsprechen den beim Sägen entstandenen Sägespuren 4. Das Halterungsbett 2 ist zusammen mit dem Träger 1 in einer Ebene bewegbar, um einen zum Abnehmen bestimmten Chip 5 in eine Position zu bringen, in welcher er von einem beispielhaft als Ansaugkopf 6 ausgebildeten Abnehmer erfaßt und einer weiteren Verarbeitung (nicht dargestellt) zugeführt wird. Bis der Chip 5 in der gewünschten Lage ausgerichtet ist, bleibt der Ansaugkopf 6 in einer Wartestellung A.

Unterhalb des Halterungsbettes 2 ist eine Auslenkvorrichtung 13 angebracht, deren Funktion im Zusammenhang mit Fig. 3 im einzelnen beschrieben wird.

Eine Lichtquelle 7 richtet einen gebündelten Lichtstrahl 8 auf einen Bereich des Trägers 1, der aus praktischen Gründen den Chip 5 und seine Umgebung, d.h. zumindest Teile der benachbarten Chips 3 umfaßt. Ein von diesen Objekten reflektierter Lichtstrahl 9 wird von einem Lichtempfänger 10 aufgenommen.

In dem gezeigten bevorzugten Ausführungsbeispiel wird das Strahlenbündel der Lichtquelle 1 über einen geneigten durchlässigen Teilerspiegel 11 gelenkt, hinter welchem der Lichtempfänger 10 so angeordnet ist, daß er alle bezüglich des Halterungsbettes 1 lotrecht reflektierten Strahlen 9 empfängt. Eine im reflektierten Strahlengang liegende Maske 12 verändert des Eindringen von Streulicht.

Fig. 2 zeigt schematisch, welches Bild von dem Chipoberflächen 3, 5 und den Sägespuren 4 vom Lichtempfänger 10, der beispielsweise aus einer optischen Einrichtung bzw. einer elektronischen Kamera bestehen kann, auf einer Bildwiedergabeeinrichtung erzeugt würde. Dabei ist deutlich zu sehen, daß wegen der relativ schmalen Sägespuren 4 nur ein sehr schwacher Helligkeitskontrast zur Oberfläche des Chips 5 besteht.

Gemäß Fig. 3 wirkt die Auslenkeinrichtung 13 auf den Chip 15 und den sich anschließenden Bereich des Trägers mit den benachbarten Chips 3 in der Weise, daß die Reflektionsflächen gegenüber ihrer ursprünglichen Lage geändert werden. Der Chip 5 wird planparallel relativ zum Halterungsbett 1 verschoben. Im bevorzugten Ausführungsbeispiel ist dazu die Auslenkeinrichtung 13 als Stempel ausgebildet, die eine Hubbewegung in Pfeilrichtung ausführt. Die benachbarten Chips 3 werden dabei jedoch nur einseitig angehoben, so daß ihre Oberflächen eine geneigte Reflexionsfläche bilden. Die auftreffenden Lichtstrahlen werden deshalb lediglich von der Oberfläche des Chips in ihren Reflexionswinkel unverändert gebündelt zum Lichtempfänger 10 zurückgeworfen, wobei der Strahlengang 15 zusätzlich durch die Maske eingegrenzt ist. Da die Oberflächen der benachbarten Chips 3 nunmehr unter einem Winkel relativ zur Oberfläche des Chips 5 angeordnet sind, werden die auftreffenden Lichtstrahlen abgelenkt und außerhalb des Empfangsbereichs des Empfängers 10 gestreut (Strahlengang 16).

Auf der Anzeigevorrichtung ist daher entsprechend der schematischen Darstellung der Fig. 4 ein starker Helligkeitskontrast zu bemerken: die abgewinkelten Chips 3 wirken gegenüber dem Chip 5 als dunkles Umfeld 14.

Aufgrund dieser Anzeige kann der Träger 1 mitsamt dem Chip 5 relativ zu einer Normalposition ausgerichtet werden, die beispielsweise durch ein Fadenkreuz auf der Bildwiedergabeeinrichtung gekennzeichnet sein kann, und in der die Arbeitsposition B des Ansaugkopfes 6 in der gewünschten Weise mit der Lage des Chips 5 übereinstimmt. Der Ansaugkopf 6 kann — vorzugsweise nach dem Rückführen der Auslenkeinrichtung 13 ion die Ausgangslage — auf den Chip 5 aufgesetzt werden (Fig. 5).

**Patentansprüche**

1. Verfahren zur Lagebestimmung eines Objektes (5) relativ zu einer Normalposition, in einem automatisierten Fertigungsverfahren, wobei sich das Objekt (5) zusammen mit einer Vielzahl von gleichartigen Objekten (3) auf einer elastischen Folie (1) befindet, beispielsweise Halbleiterchips in einer Bond-Vorrichtung und wobei der Helligkeitskontrast innerhalb eines vom Objekt und seiner unmittelbaren Umgebung reflektierten Strahlenbündels als Bestimmungskriterium dient, dadurch gekennzeichnet, daß das Objekt (5) in Richtung senkrecht zu seiner Reflexionsfläche angehoben wird, wodurch die angrenzenden gleichartigen Objekte (3) in eine Schrägle geraten, so daß aufgrund der unterschiedlichen Neigung der Reflexionsflächen der Strahlengang der vom Objekt (5) reflektierten Strahlen (15) vom Strahlengang (16) der von den übrigen Objekten (3) reflektierten Strahlen getrennt und der Auswertung zugeführt wird.

2. Vorrichtung zur Lagebestimmung eines Objektes (5) relativ zu einer Normalposition, in einem automatisierten Fertigungsverfahren, wobei sich das Objekt (5) zusammen mit einer Vielzahl von gleichartigen Objekten (3) auf einer elastischen Folie (1) befindet, mit einer Lichtquelle (7) zur Erzeugung eines auf das Objekt (5) und seine unmittelbare Umgebung (3) gerichteten gebündelten Lichtstrahls (8), und mit einem Lichtempfänger (10), gekennzeichnet durch eine Anhebvorrichtung (13), die aus einem stempelartigen Körper besteht, der unterhalb einer Ebene, in der die Folie (1) mit den Objekten positioniert werden kann, angeordnet und lotrecht bezüglich der Ebene bewegbar ist, so daß bei Betätigung des stempelartigen Körpers das Objekt (5) relativ zu seiner Umgebung derart angehoben wird, daß aufgrund der unterschiedlich ausgerichteten Reflexionsflächen die vom Objekt (5) reflektierten Strahlen (15) in den Lichtempfänger (10) und die von den übrigen Objekten (3) reflektierten Strahlen (16) in einen Bereich außerhalb des Empfangsbereichs des Empfängers (10) gerichtet werden.

**Revendications**

1. Procédé pour déterminer la position d'un objet (5) par rapport à une position normale, dans un procédé de fabrication automatisé, et selon lequel l'objet (5), ainsi qu'une mutiplicité d'objets identiques (3), est situé sur une feuille élastique (1), par exemple des microplaquettes à semiconducteurs dans un dispositif de liaison, et selon lequel le contraste de luminosité à l'intérieur d'un faisceau de rayonnement réfléchi par l'objet et son environnement immédiat, est utilisé comme critère de détermination, caractérisé par le fait qu'on soulève l'objet (5) dans une direction perpendiculaire à sa surface réfléchissante, ce qui a pour effet que les objets identiques voisins (3) viennent se placer dans une position oblique de sorte qu'en raison de l'inclinaison différente des surfaces réfléchissantes, le trajet des rayons (15) réfléchis par l'objet (5) est séparé du trajet (16) des rayons réfléchis par les autres objets (3) et est évalué.

2. Dispositif pour déterminer la position d'un objet (5) par rapport à une position normale dans une procédé de fabrication automatisé, pour lequel l'objet (5), ainsi qu'une multiplicité d'objets identiques (3), est situé sur une feuille élastique (1), et comportant une source de lumière (7) servant à produire un faisceau de lumière focalisé (8), dirigé vers l'objet (5) et son environnement immédiat (3), et un récepteur de lumière (10), caractérisé par un dispositif de soulèvement (13) constitué par un corps en forme de poinçon, qui est disposé au-dessous d'un plan dans lequel peut être placée la feuille (1) munie des objets, et déplaçable perpendiculairement au plan, de sorte que, lors de l'actionnement du corps en forme de poinçon, l'objet (5) est soulevé par rapport à son environnement si bien que par suite de l'orientation différente des surfaces réfléchissantes, les rayons (15) réfléchis par l'objet (5) sont dirigées dans le récepteur de lumière (10) et des rayons (7) réfléchis par les autres objets (3) sont dirigés dans une zone située à l'extérieur de la zone de réception du récepteur (10).

## Claims

1. Method of determining the position of an object (5) relative to a normal position, in an automated production process, the object (5) being located, together with a plurality of similar objects (3), on an elastic foil (1), for example semiconductor chips in a bonding device, and the brightness contrast inside a ray bundle reflected from the object and its immediate surroundings serving as determining criterion, characterized in that the object (5) is lifted in the direction perpendicular to its reflection surface, whereby the adjacent similar objects (3) come into an inclined position, so that, because of the differing inclination of the reflection surfaces, the ray path of the rays (15) reflected from the object (5) is separated from the ray path (16) of the rays reflected from the remaining objects (3), and is fed to evaluation.

2. Device for determining the position of an object (5) relative to a normal position, in an automated production process, the object (5) being located, together with a plurality of similar objects (3), on an elastic foil (1), comprising a light source (7) for generating a focused light beam (8) directed towards the object (5) and its immediate surroundings (3), and comprising a light receiver (10), characterized by a lifting device (13) which consists of a plunger-like body, which is disposed below a plane, in which the foil (1) can be positioned with the objects, and is movable perpendicular relative to the plane, so that, upon actuation of the plunger-like body, the object (5) is lifted relative to its surroundings in such a way that, because of the differently aligned reflection surfaces, the rays (15) reflected from the object (5) are directed into the light receiver (10), and the rays (16) reflected from the remaining objects (3) are directed into a region outside the receiving range of the receiver (10).

EP 0 194 487 B1

FIG 1

FIG 3

FIG 5

FIG 2

FIG 4